# EUROPEAN PATENT SPECIFICATION

(11) **EP 0 362 694 B1**
(45) Date of publication and mention of the grant of the patent: **04.01.1995**
(21) Application number: 89117954.1
(22) Date of filing: 28.09.1989
(51) Int. Cl.: C04B 35/00, C04B 35/64, H01L 39/24

(54) **Method of producing oxide superconducting wire**
Verfahren zur Herstellung eines oxidischen supraleitenden Drahts
Procédé pour la production de fil d'oxyde supraconducteur

(30) Priority: 28.09.1988 JP 245266/88; 31.07.1989 JP 199969/89
(43) Date of publication of application: 11.04.1990
(73) Proprietor: SUMITOMO ELECTRIC INDUSTRIES, LTD., Osaka-shi, Osaka 541 (JP)
(72) Inventor: Hikata, Takeshi c/o Osaka Works of Sumitomo, Konohana-ku Osaka (JP); Sato, Kenichi c/o Osaka Works of Sumitomo, Konohana-ku Osaka (JP); Torii, Yasuko c/o Osaka Works of Sumitomo, Konohana-ku Osaka (JP); Takei, Hiromi c/o Osaka Works of Sumitomo, Konohana-ku Osaka (JP)
(74) Representative: KUHNEN, WACKER & PARTNER

(56) References cited:
- EP-A- 0 281 474
- EP-A- 0 302 791
- EP-A- 0 308 326

## Description

### BACKGROUND OF THE INVENTION

### Field of the Invention

The present invention relates to a method of producing a Tl-Ba-Ca-Cu oxide superconducting. wire Description of the Background Art

A specific material exhibits diamagnetism under a superconducting phenomenon such that no potential difference is appeared although a finite stationary current flows in its interior.

This superconducting phenomenon is applied to an extremely wide range of fields such as that of electric power fields including MHD power generation, power transmission and magnetic energy storage and that of transportation including a magnetic levitation train and an electromagnetically thrust ship. Further, a high-sensitive sensor for a magnetic field, a high frequency, radiation or the like using the superconducting phenomenon is applied to the field of measurement, and also superconductors are used in the field of including nuclear magnetic resonance (NMR), π-meson remedy and a high energy physical experimental apparatus, while the superconducting phenomenon is also expected in the field of electronics, which is represented by the Josephson device, as a technique which can not only reduce power consumption but implement an element of extremely high-speed operation.

Superconductivity was until recently observed only under a very low temperature. Even Nb₃Ge, which has been referred to as that having the highest critical temperature T_{C} of superconductivity within conventional superconducting materials, has an extremely low critical temperature of 23.2 K, which has been regarded as the limit critical temperature of superconduction for a long period of time.

Therefore, a superconducting material has been generally cooled to a temperature below the critical temperature T_{C} with liquid helium which boils at 4.2 K, in order to realize a superconducting phenomenon. However, such employment of liquid helium leads to technical and economic burdens due to cooling equipment including Refrigeration equipment, to hinder implementation of the superconducting technique.

However, it has been recently reported that a composite oxide sintered body can show superconductivity at a high critical temperature, and development of the superconducting technique is abruptly being prompted with a superconductor whose critical temperature is not very low. It has been reported that a Y-Ba-Cu-O oxide superconductor superconducts at 90 K and a Tl-Ba-Ca-Cu oxide superconductor superconducts at 125 K respectively.

Liquid nitrogen is relatively easily obtainable at a low cost, and in fact, development of the superconducting technique has been greatly advanced with discovery of a superconducting material which operates at the temperature of liquid nitrogen. However, in practical application to a superconducting magnet, a wiring member for a device, a power cable or the like, for example, it is necessary to attain not only a high critical temperature but current density exceeding 1000 A/cm², the current density of copper used with liquid nitrogen.

EP-A-0 281 474 discloses a process for manufacturing a wire comprising the preparation of a mass of oxide having superconductivity from powder material, covering the mass of oxide with a metal pipe and then reducing the diameter of the metal pipe containing the mass of oxide into a wire form by plastic deformation, preferably by swaging.

EP-A-0 302 791 and EP-A-0 308 326 have a publication date between the two priority dates of the present patent application. These applications disclose processes for an elongated sintered article or superconductor, respectively. Both comprise the steps of filling a metal pipe with powdered material, carrying out plastic deformation on the metal pipe, and then subjecting the material powder in deformed metal pipe to sintering operation.

### Summary of the invention

An object of the present invention is to provide a method of producing a superconductor which shows superconductivity under a temperature of at least 100 K, by far exceeding the temperature of liquid nitrogen, and which can increase critical current density.

The present invention provides a method of producing an oxide superconducting wire of Tl-Ba-Ca-Cu from a raw material, which method comprises steps of performing first plastic deformation on said raw material, performing first heat treatment on said raw material being subjected to said first plastic deformation, performing second plastic deformation on said material being subjected to said first heat treatment, and performing second heat treatment on said material being subjected to said second plastic deformation, wherein said first heat treatment, said first and second plastic deformation and said second heat treatment are performed in a state enclosed by a metal sheath.

According to the inventive producing method, the 2nd plastic deformation step is inserted between the first heat treatment and the second heat treatment to increase denseness of the oxide superconductor as well as to improve its orientation property, thereby to extremely improve current density.

An exemplary Tl-Ba-Ca-Cu oxide superconducting wire produced according to the present invention is composed of:

TlₖBa_{ℓ}CaₘCuₙ and oxygen

where k, ℓ, m and n represent numbers satisfying 1 ≦ k, ℓ, m ≦ 3 and n ≧ 2.

In the case of the Tl-Ba-Ca-Cu oxide superconductor having the above composition, the first heat treatment and the second heat treatment are preferably carried out within a temperature range of 800 to 1000°C.

An element of the Tl-Ba-Ca-Cu oxide superconductor produced according to the present invention may be partially replaced by another element. For example, Tl may be partially replaced by Pb. A superconductor thus obtained by partially replacing Tl by Pb exhibits high current density. An example of such a superconductor is composed of:

(Tl₁₋ₓ,Pbₓ)_{y}Ba₂Caₙ₋₁Cuₙ and oxygen

where x, y and n represent numbers satisfying 0 ≦ x < 1, 0.5 < y < 3 and n ≧ 2.

With respect to the above composition, the first heat treatment and the second heat treatment are preferably carried out within a temperature range of 700 to 900°C.

In the above composition, further, x preferably satisfies 0 ≦ x ≦ 0.5.

In addition, it is preferable that x is around 0.1, n is around 4 and y is around 2 in the above composition, in consideration of blending.

A material having such composition is subjected to heat treatment in the air atmosphere or in an oxygen atmosphere, whereby the Tl component volatilizes so that y is around 1. Powder of this material is charged in a metal sheath to provide a wire having excellent characteristics.

In the inventive producing method, the first heat treatment, the 1st and 2nd plastic deformation and the second heat treatment are performed in a state enclosed by a metal sheath. In this case, the metal sheath is preferably formed of gold, gold alloy, silver or silver alloy.

In the inventive producing method, the 2nd plastic deformation is preferably deformation with a reduction in area of at least 10 % and/or a load of at least 1000 kg/cm² (1 ton/cm²). Further, the second plastic deformation is preferably rolling, pressing and/or wire drawing.

According to the present invention, the second plastic deformation is performed after the first heat treatment and then the second heat treatment is performed. In advance of the first heat treatment the raw material is previously subjected to a first plastic deformation. Higher current density can be attained through such a first plastic deformation performed in advance of the first heat treatment.

According to the inventive producing method, the second plastic deformation step is inserted between the first heat treatment and the second heat treatment, thereby to increase denseness of the superconductor as well as to improve the orientation property thereof. Thus, a superconductor having higher current density as compared to the prior art can be produced.

These and other objects, features, aspects and advantages of the present invention will become more apparent from the following detailed description of the present invention.

### DESCRIPTION OF THE PREFERRED EMBODIMENTS

### Example I

Commercially available Tl₂O₃ powder, BaCO₃ powder, CaCO₃ powder and CuO powder were mixed in the ratios 2:2:2:3. This mixture was pulverized, mixed, calcined at 800°C for eight hours, subjected to heat treatment at 860°C for 16 hours, and charged in a gold pipe of 4 mm in inner diameter and 6 mm in outer diameter, to be drawn into a wire of 1 mm in diameter. Samples of such a wire were subjected to first heat treatment at 860°C for 12 hours in the atmosphere. Thereafter the samples were rolled with drafts of various reductions in sectional area shown in Table 1, and then subjected to second heat treatment at 860°C for 12 hours. Table 1 shows critical temperatures and critical current density values of these samples. The critical current density values were measured under a temperature of 77.3 K.

For reference, a sample No. I-8 was prepared by charging a raw material in a gold pipe similarly to the above, drawing the same into a wire of 1 mm in diameter and performing heat treatment on the wire only once. Table 1 also shows the critical temperature and the critical current density of this sample.

**Table 1**

| No. | Reduction in Sectional Area (%) | Critical Temperature (K) | Current Density (A/cm²) |
|---|---|---|---|
| I-1 | 7 | 118 | 750 |
| I-2 | 13 | 118 | 1240 |
| I-3 | 24 | 118 | 2050 |
| I-4 | 30 | 117 | 2500 |
| I-5 | 37 | 117 | 2800 |
| I-6 | 49 | 117 | 4560 |
| I-7 | 73 | 117 | 4520 |
| I-8 | -- | 118 | 400 |

As clearly understood from Table 1, the inventive wires of sample Nos. I-1 to I-7 are superior in critical current density to the sample No. I-8 according to the prior art. In particular, those worked with reductions in sectional area of at least 10 %, more preferably at least 20 %, exhibit particularly excellent critical current density values.

### Example II

Description is now made on Example II, in which Tl is partially replaced by Pb.

Commercially available Tl₂O₃ powder, PbO powder, BaO powder, CaO powder and CuO powder were mixed in the ratios 1.8:0.2:2:3:4. This mixture was pulverized, mixed, subjected to heat treatment at 870°C for 12 hours, thereafter charged in a silver pipe of 4 mm in inner diameter and 6 mm in outer diameter to be drawn into a wire of 2 mm in diameter, and then rolled into a tape of 0.15 mm in thickness. Samples of such a tape-type wire were subjected to first heat treatment at 780°C for one hour in the atmosphere. Thereafter the samples were rolled with drafts of various reductions in sectional area shown in Table 2, and then subjected to second heat treatment at 780°C for four hours. Table 2 shows critical temperatures of these samples and critical current density values measured at 77.3 K.

For reference, a sample No. II-8 was prepared by performing heat treatment only once on a tape-type wire in accordance with a conventional method. Table 2 also shows the critical temperature and the critical current density of this sample.

**Table 2**

| No. | Reduction in Sectional Area (%) | Critical Temperature (K) | Current Density (A/cm²) |
|---|---|---|---|
| II-1 | 5 | 115 | 840 |
| II-2 | 14 | 115 | 1980 |
| II-3 | 23 | 115 | 3730 |
| II-4 | 29 | 115 | 4000 |
| II-5 | 32 | 115 | 7020 |
| II-6 | 51 | 115 | 9800 |
| II-7 | 72 | 115 | 9500 |
| II-8 | -- | 115 | 700 |

As clearly understood from Table 2, the inventive wires of sample Nos. II-1 to II-7 exhibit higher current density values as compared with the sample No. II-8 according to the prior art. In particular, the wires worked with reductions in area of at least 10 %, more preferably at least 20 %, exhibit excellent critical current density values.

### Example III

Description is now made on the case of performing plastic deformation on Example III, in which Tl is partially replaced by Pb, with application of a load.

Commercially available Tl₂O₃ powder, PbO powder, BaO powder, CaO powder and CuO powder were mixed in the ratios 1.8:0.2:2:3:4. This mixture was pulverized, mixed, subjected to heat treatment at 870°C for 12 hours and charged in a silver pipe of 4 mm in inner diameter and 6 mm in outer diameter to be drawn into a wire of 2 mm in diameter, and further rolled into a tape of 0.15 mm in thickness. Samples of such a tape-type wire were subjected to first heat treatment at 780°C for one hour in the atmosphere. Then the samples were pressed under various loads shown in Table 3, and subjected to second heat treatment at 780°C for four hours. Table 3 shows critical temperatures of these samples and critical current density values measured at 77.3 K.

For reference, a sample No. III-8 was prepared by performing heat treatment only once on a tape-type wire in accordance with a conventional method. Table 3 also shows the critical temperature and the critical current density of this sample.

**Table 3**

| No. | Load (ton/cm²) | Critical Temperature (K) | Current Density (A/cm²) |
|---|---|---|---|
| III-1 | 0.5 | 115 | 920 |
| III-2 | 1 | 115 | 1360 |
| III-3 | 5 | 115 | 1910 |
| III-4 | 10 | 115 | 4500 |
| III-5 | 20 | 115 | 7800 |
| III-6 | 50 | 115 | 9930 |
| III-7 | 100 | 115 | 9880 |
| III-8 | - | 115 | 700 |

As clearly understood from Table 3, the inventive wires of sample Nos. III-1 to III-7 exhibit higher current density values as compared with the sample No. III-8 according to the prior art. In particular, the wires worked with loads of at least 1 ton/cm², more preferably at least 10 ton/cm², exhibit excellent critical current density values.

## Claims

1. A method of producing an oxide superconducting wire of Tl-Ba-Ca-Cu from a raw material, said method comprising the following steps:
performing first plastic deformation on said raw material,
performing first heat treatment on said raw material being subjected to said first plastic deformation,
performing second plastic deformation on said material being subjected to said first heat treatment and
performing second heat treatment on said material being subjected to said second plastic deformation,
wherein said first heat treatment, said first and second plastic deformation and said second heat treatment are performed in a state enclosed by a metal sheath.

2. A method of producing an oxide superconducting wire in accordance with claim 1, wherein said oxide superconducting wire of Tl-Ba-Ca-Cu is composed of:
TlₖBaₗCaₘCuₙ and oxygen
where k, l, m and n represent numbers satisfying 1 ≦ k, l, m ≦ 3 and n ≧ 2.

3. A method of producing an oxide superconducting wire in accordance with claim 1 or 2, wherein said first heat treatment and said second heat treatment are carried out within a temperature range of 800 to 1000°C.

4. A method of producing an oxide superconducting wire in accordance with any of claims 1-3, wherein said oxide superconducting wire of Tl-Ba-Ca-Cu is a superconductor in which Tl is partially replaced by Pb.

5. A method of producing an oxide superconducting wire in accordance with any of claims 1-4, wherein said oxide superconducting wire of Tl-Ba-Ca-Cu is composed of:
(Tl₁₋ₓ,Pbₓ)_{y}Ba₂Caₙ₋₁Cuₙ and oxygen
where x, y and n represent numbers satisfying 0 ≦ x < 1, 0.5 < y < 3 and n ≧ 2.

6. A method of producing an oxide superconducting wire in accordance with any of claims 4 or 5, wherein said first heat treatment and said second heat treatment are carried out within a temperature range of 700 to 900°C.

7. A method of producing an oxide superconducting wire in accordance with claim 5 or 6, wherein said x satisfies 0 ≦ x ≦ 0.5.

8. A method of producing an oxide superconducting wire in accordance with any of claims 1-7, wherein said second plastic deformation is deformation with a reduction in sectional area of at least 10 %.

9. A method of producing an oxide superconducting wire in accordance with any of claims 1-8, wherein said second plastic deformation is working with a load of at least 1000 kg/cm² (1 ton/cm²).

10. A method of producing an oxide superconducting wire in accordance with any of claims 1-9, wherein said second plastic deformation is rolling, pressing and/or wire drawing.

11. A method of producing an oxide superconducting wire in accordance with any of claims 1-10, wherein said metal sheath is formed of gold, gold alloy, silver or silver alloy.

## Patentansprüche

1. Ein verfahren zum Herstellen eines oxidischen supraleitenden Drahtes aus Tl-Ba-Ca-Cu aus einem Rohmaterial, wobei das Verfahren die folgenden Schritte umfaßt:
Durchführen einer ersten plastischen Verformung an dem Rohmaterial,
Durchführen einer ersten Wärmebehandlung an dem Rohmaterial, welches der ersten plastischen Verformung ausgesetzt wurde,
Durchführen einer zweiten plastischen Verformung an dem Material, welches der ersten Wärmebehandlung ausgesetzt wurde, und
Durchführen einer zweiten Wärmebehandlung an dem Material, welches der zweiten plastischen Verformung ausgesetzt wurde,
wobei die erste Wärmebehandlung, die erste und zweite plastische Verformung und die zweite Wärmebehandlung in einem Zustand, eingeschlossen von einer Metallhülle, durchgeführt werden.

2. Verfahren zum Herstellen eines oxidischen supraleitenden Drahtes nach Anspruch 1, wobei der oxidische supraleitende Draht aus Tl-Ba-Ca-Cu zusammengesetzt ist aus:
TlₖBaₗCaₘCuₙ und Sauerstoff,
wobei k, l, m und n Zahlen darstellen, die 1 ≦ k, l, m ≦ 3 und n ≧ 2 erfüllen.

3. Verfahren zum Herstellen eines oxidischen supraleitenden Drahtes nach Anspruch 1 oder 2, wobei die erste Wärmebehandlung und die zweite Wärmebehandlung durchgeführt werden innerhalb eines Temperaturbereiches von 800 bis 1000°C.

4. Verfahren zum Herstellen eines oxidischen supraleitenden Drahtes nach irgendeinem der Ansprüche 1 bis 3, wobei der oxidische supraleitende Draht aus Tl-Ba-Ca-Cu ein Supraleiter ist, in welchem Tl teilweise durch Pb ersetzt wird.

5. Verfahren zum Herstellen eines oxidischen supraleitenden Drahtes nach irgendeinem der Ansprüche 1 bis 4, wobei der oxidischen supraleitende Draht aus Tl-Ba-Ca-Cu zusammengesetzt ist aus:
Tl₁₋ₓ,Pbₓ)_{Y}Ba₂Caₙ₋₁Cuₙ und Sauerstoff,
wobei x, y und n Zahlen darstellen, die 0 ≦ x <1, 0,5 < y < 3 und n ≧ 2 erfüllen.

6. Verfahren zum Herstellen eines oxidischen supraleitenden Drahtes gemäß einem der Ansprüche 4 oder 5, wobei die erste Wärmebehandlung und die zweite Wärmebehandlung durchgeführt werden innerhalb eines Temperaturbereiches von 700 bis 900°C.

7. Verfahren zum Herstellen eines oxidischen supraleitenden Drahtes nach Anspruch 5 oder 6, wobei die x 0 ≦ x ≦ 0,5 erfüllen.

8. Verfahren zum Herstellen eines oxidischen supraleitenden Drahtes nach irgendeinem der Ansprüche 1 bis 7, wobei die zweite plastische Verformung eine Verformung ist mit einer Verminderung der Schnittfläche von wenigstens 10%.

9. Verfahren zum Herstellen eines oxidischen supraleitenden Drahtes nach irgendeinem der Ansprüche 1 bis 8, wobei die zweite plastische verformung mit einer Last von wenigstens 1000 kg/cm² (1 Tonne/cm²) arbeitet.

10. Verfahren zum Herstellen eines oxidischen supraleitenden Drahtes nach irgendeinem der Ansprüche 1 bis 9, wobei die zweite plastische Verformung Rollen, Pressen und/oder Drahtziehen ist.

11. Verfahren zum Herstellen eines oxidischen supraleitenden Drahtes nach irgendeinem der Ansprüche 1 bis 10, wobei die Metallhülle aus Gold, Goldlegierung, Silber oder Silberlegierung gebildet ist.

## Revendications

1. Procédé pour produire un fil en oxyde supraconducteur de Tl-Ba-Ca-Cu à partir d'un matériau brut, ledit procédé comprenant les étapes suivantes consistant à :
effectuer une première déformation plastique sur ledit matériau brut,
effectuer un premier traitement thermique sur ledit matériau brut qui a été soumis à ladite première déformation plastique,
effectuer une seconde déformation plastique sur ledit matériau qui a été soumis audit premier traitement thermique, et
effectuer un second traitement thermique sur ledit matériau qui a été soumis à ladite seconde déformation plastique,
dans lequel ledit premier traitement thermique, lesdites première et seconde déformations plastiques et ledit second traitement thermique sont effectués dans un état enfermé dans une enveloppe métallique.

2. Procédé pour produire un fil en oxyde supraconducteur selon la revendication 1, dans lequel le fil en oxyde supraconducteur de Tl-Ba-Ca-Cu est constitué de
TlₖBAₗCaₘCuₙ et d'oxygène
où k, l, m et n représentent des nombres satisfaisant 1 ≦ k, l, m ≦ 3 et n ≧ 2.

3. Procédé pour produire un fil en oxyde supraconducteur selon la revendication 1 ou 2, dans lequel ledit premier traitement thermique et ledit second traitement thermique sont effectués dans les limites d'une plage de température située entre 800 et 1000°C.

4. Procédé pour produire un fil en oxyde supraconducteur selon l'une quelconque des revendications 1 à 3, dans lequel ledit fil en oxyde supraconducteur de Tl-Ba-Ca-Cu est un supraconducteur dans lequel Tl est partiellement remplacé par Pb.

5. Procédé pour produire un fil en oxyde supraconducteur selon l'une quelconque des revendications 1 à 4, dans lequel ledit fil en oxyde supraconducteur de Tl-Ba-Ca-Cu est constitué de :
(Tl₁₋ₓ, Pbₓ)_{y}Ba₂Caₙ₋₁Cuₙ et d'oxygène
où x, y et n représentent des nombres satisfaisants 0 ≦ x < 1, 0,5 < y < 3 et n ≧ 2.

6. Procédé pour produire un fil en oxyde supraconducteur selon l'une quelconque des revendications 4 ou 5, dans lequel ledit premier traitement thermique et ledit second traitement thermique sont effectués dans les limites d'une plage de température située entre 700 et 900°C.

7. Procédé pour produire un fil en oxyde supraconducteur selon la revendication 5 ou 6, dans lequel ledit x satisfait 0 ≦ x ≦ 0,5.

8. Procédé pour produire un fil en oxyde supraconducteur selon l'une quelconque des revendications 1 à 7, dans lequel ladite seconde déformation plastique est une déformation accompagnée d'une réduction en section transversale d'au moins 10 %.

9. Procédé pour produire un fil en oxyde supraconducteur selon l'une quelconque des revendications 1 à 8, dans lequel ladite seconde déformation plastique est effectuée avec une charge d'au moins 1000 Kg/cm² (1 tonne/cm²).

10. procédé pour produire un fil en oxyde supraconducteur, selon l'une quelconque des revendications 1 à 9, dans lequel ladite seconde déformation plastique est effectuée par laminage, compression et/ou étirage de fil.

11. Procédé pour produire un fil en oxyde supraconducteur selon l'une quelconque des revendications 1 à 10, dans lequel ladite enveloppe métallique est constituée d'or, d'alliage d'or, d'argent ou d'alliage d'argent.
